# EUROPEAN PATENT APPLICATION

(11) **EP 4 831 659 A1**
(43) Date of publication of application: **28.10.2026**
(21) Application number: 26171959.5
(22) Date of filing: 13.04.2026
(51) Int. Cl.: G01R 31/28

(54) **ENHANCED STRESS EVALUATION ASSOCIATED WITH A SEMICONDUCTOR DEVICE**

(30) Priority: 14.04.2025 US 202519177818
(71) Applicant: Avago Technologies International Sales Pte. Limited, Singapore 768923 (SG)
(72) Inventor: PAL, Rohit, Irvine, 92618 (US); LI, Xiaoming, Irvine, 92618 (US); TSAU, Liming, Irvine, 92618 (US); YONG, Yoong Hooi, Irvine, 92618 (US)
(74) Representative: Dilg, Haeusler, Schindelmann Patentanwaltsgesellschaft mbH

(57) **Abstract**

A system may regulate at least one of a voltage or a current of a first device and a second device disposed on a substrate at a location associated with a region of the substrate and may measure attributes of a first device and a second device. The system may determine, based on the attributes, values indicative of stress associated with the region. The system may generate a representation of the values indicative of the stress associated with the region.

## Description

### BACKGROUND

Semiconductor devices are subjected to stresses at various times, such as during various stages of processing. For example, semiconductor devices are typically subjected to stresses during wafer fabrication processes, dicing processes, and/or packaging processes, among other examples.

### SUMMARY

Some implementations described herein provide a system, including: circuitry configured to: regulate at least one of a voltage or a current of a first device and a second device disposed on a substrate at a location associated with a region of the substrate; measure attributes of the first device and a second device; determine, based on the attributes, values indicative of stress associated with the region; and generate, based on the values, a representation of the values indicative of the stress associated with the region.

Some implementations described herein provide a device, including: a substrate including a region; a first device and a second device disposed on the substrate in proximity to the region; and circuitry configured to: measure first attributes of the first device and second attributes of the second device, wherein the first attributes and the second attributes are associated with stress associated with the region.

Some implementations described herein provide a method, including: measuring, by a device, attributes of a first device and a second device disposed on a substrate at a location corresponding to a region of the substrate; determining, by the device and based on the attributes, values indicative of stress associated with the region; and generating, by the device and based on the values, a representation of the values indicative of the stress associated with the region.

### BRIEF DESCRIPTION OF THE DRAWINGS

Figs. 1A-1D are diagrams of an example associated with enhanced stress evaluation associated with a semiconductor device.
Fig. 2 is a diagram of an example associated with enhanced stress evaluation associated with a semiconductor device.
Fig. 3 is a diagram illustrating an example of training and using a machine learning model in connection with enhanced processing associated with a semiconductor device.
Fig. 4 is a diagram of an example device associated with enhanced stress evaluation associated with a semiconductor device.
Fig. 5 is a flowchart of an example process associated with enhanced stress evaluation associated with a semiconductor device.

### DETAILED DESCRIPTION

The following detailed description of example implementations refers to the accompanying drawings. The same reference numbers in different drawings may identify the same or similar elements.

Stresses applied to semiconductor devices can lead to various performance and reliability issues, such as cracking or failure in one or more areas associated with the semiconductor devices. To mitigate negative effects of these stresses, the stresses may be measured and analyzed. However, typical stress measurement techniques often only measure aggregate stress values across the semiconductor devices, which limits their effectiveness in identifying issues associated with the stresses.

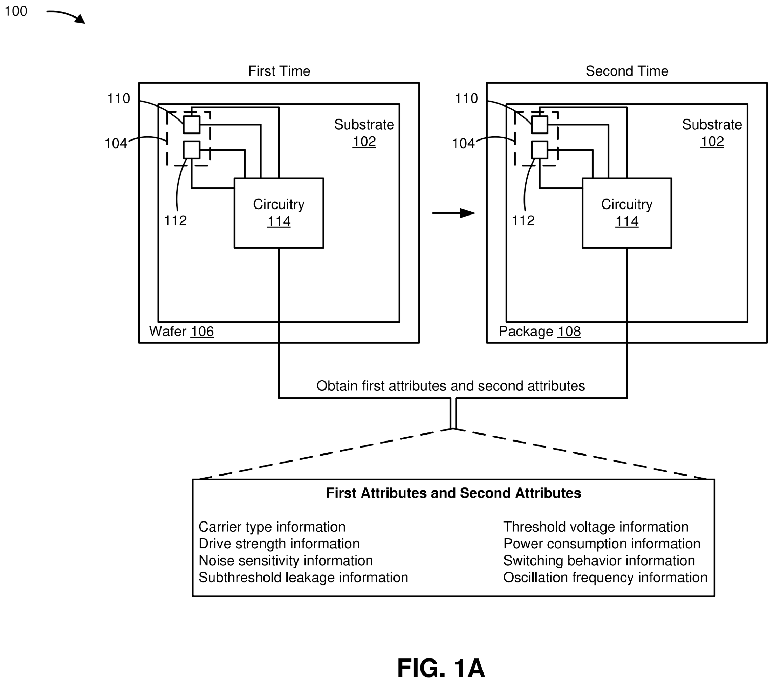

Figs. 1A-1D are diagrams of an example 100 associated with enhanced stress evaluation associated with a semiconductor device. As shown in Figs. 1A-1D, the example 100 may include a substrate 102 (e.g., shown as including a region 104), a wafer 106, a package 108, a first device 110, a second device 112, circuitry 114, and a data processing system 116.

In some implementations, the substrate 102 may refer to a layer (e.g., a foundational layer) configured to supports various electrical components, such as semiconductor devices and/or integrated circuits (ICs), among other examples. For example, the layer may be composed of a variety of materials, such as, silicon, organic laminate, ceramic, metal, and/or other specialized materials. A selection of materials for the substrate 102 may be based on one or more factors, such as structural integrity, electrical performance, thermal management, and/or requirements of a semiconductor package or system, among other examples. As an example, the substrate 102 may be a semiconductor die, such as a semiconductor die of an application-specific IC (ASIC) and/or a chiplet (e.g., semiconductor component that is configured to function as part of a larger IC), among other examples.

In some implementations, the substrate 102 may undergo various processing, such as wafer fabrication processing, dicing processing, and/or packaging processing, among other examples. For example, the substrate 102, including the region 104, may be fabricated as part of the wafer 106 (e.g., through one or more wafer fabrication processes), separated from the wafer 106 (e.g., using one or more dicing processes), and packaged (e.g., encapsulated) into the package 108 (e.g., through one or more packaging processes), among other examples.

In some implementations, the processing and/or techniques used to form the substrate 102, including the region 104, may be replicated in subsequent substrates. For example, the processing and/or techniques used to form the substrate 102 may be used to form a subsequent substrate (e.g., a future substrate) with a subsequent region that at least one of matches, or substantially matches, the region 104 (e.g., the subsequent region and the region 104 may have at least one of matching, or substantially matching, material compositions and/or structural designs, among other examples).

In some implementations, the substrate 102 may be subjected to stress (e.g., different stress types) at various points in time (e.g., different points in time). For example, the substrate 102 may be subjected to mechanical stress, thermal stress, and/or electrical stress, such as during processing (e.g., wafer fabrication, dicing, and/or packaging processing) and/or during operation (e.g., in a packaged device), among other examples.

For example, mechanical stress may refer to stress induced by physical forces applied to the substrate 102. The mechanical stress may include compressive stress and/or tensile stress. For example, compressive stress may refer to stress where the substrate 102 is compressed (e.g., one or more materials and/or components of the substrate 102 may be subjected to compressive stress during coupling and/or attachment to other components and/or during packaging, among other examples). For example, tensile stress may refer to stress where the substrate 102 is stretched or pulled (e.g., one or more materials and/or components of the substrate 102 may be subjected to tensile stress during dicing, where forces may be applied to separate the substrate 102 from the wafer), among other examples.

As another example, thermal stress may refer to stress induced by temperature variations applied to the substrate 102 (e.g., temperature variations may cause one or more materials and/or components of the substrate 102 to expand or contract at differing rates, leading to potential warping, cracking, and/or delamination, among other examples). As another example, electrical stress may refer to stress induced by electrical currents, voltages, or electromagnetic fields that affect the substrate 102 (e.g., voltage fluctuations may apply electrical stress to one or more components of the substrate 102), among other examples.

In some implementations, the stress may affect the substrate 102 at various locations on the substrate 102. For example, the stress may affect the region 104 of the substrate 102. In some implementations, the region 104 may be associated with an edge of the substrate 102, a corner of the substrate 102, and/or a sensitive area of the substrate 102 (e.g., as shown in Figs. 1A-1B, the region 104 is associated with a corner of the substrate 102). For example, a sensitive area may refer to a location on the substrate 102 that experiences higher levels of stress, temperature, and/or electrical activity compared to other areas on the substrate 102, which, in turn, causes the location to be more susceptible to negative effects of stress relative to locations on the substrate 102 experiencing lower levels of stress, temperature, and/or electrical activity.

In some implementations, stresses affecting the substrate 102 may evolve over time. For example, stresses affecting the region 104 may progress from a time when the substrate 102 is part of the wafer 106 to a time when the substrate 102 is part of the package 108, among other examples. In other words, stresses affecting the region 104, such as stresses associated with wafer fabrication, dicing, and/or packaging, may progress over time. The stresses affecting the region 104 may influence a performance, a structural integrity, and/or a longevity of the region 104, among other examples.

In some implementations, the first device 110 and the second device 112 may be configured to operate at a location associated with the region 104 (e.g., a location corresponding to the region 104). For example, the first device 110 and the second device 112 may be positioned at a location that is within the region 104, at a location that is at least partially within the region 104, or at a location that is in proximity to the region 104, among other examples.

In some implementations, the first device 110 and the second device 112 may be configured to operate at the location associated with the region 104 at multiple times. For example, the first device 110 and the second device 112 may be configured to operate at the location at least at, or during, a first time (e.g., when the substrate 102 is part of the wafer 106) and at, or during, a second time (e.g., when the substrate 102 is part of the package 108), among other examples.

In some implementations, the first device 110 and the second device 112 may be associated with attributes. For example, attributes may refer to electrical and/or operational characteristics of the first device 110 and/or the second device 112, such as a voltage, a current, a resistance, an impedance, a capacitance, an inductance, a signal integrity, a frequency response, a transient response, a thermal behavior, reliability metrics, and/or other operational parameters associated with the first device 110 and/or the second device 112, among other examples.

Accordingly, and in some implementations, the attributes of the first device 110 and/or the second device 112 may be indicative of a performance of the first device 110 and/or the second device 112. For example, the attributes may be measured, such as during operation of the first device 110 and/or the second device 112 over a time period and/or under a set of operating parameters.

As an example, the attributes may be measured at an initial time of the time period, at a final time of the time period, and/or any point between the initial time and the final time. As another example, the set of operating parameters may refer to one or more environmental factors and/or functional factors (e.g., one or more temperatures, voltage levels, current levels, signal frequencies, humidities, electromagnetic interferences, power supply stabilities, load conditions, and/or other relevant operational parameters, among other examples) that influence the performance of the first device 110 and/or the second device 112). In some implementations, the attributes may be evaluated to determine the performance of the first device 110 and/or the second device 112, as described in more detail elsewhere herein.

In some implementations, the first device 110 may be associated with first attributes and the second device 112 may be associated with second attributes. For example, the first attributes (e.g., associated with the first device 110) may be different from the second attributes (e.g., associated with the first device 110). As an example, the first attributes and the second attributes may be differently affected by stress (e.g., at least a portion of the first attributes and/or the second attributes may be differently affected by stress), as described in more detail elsewhere herein.

In some implementations, the first attributes of the first device 110 may be predominantly influenced by electrical and/or operational characteristics of an n-type metal-oxide-semiconductor (NMOS) device (e.g., an NMOS transistor), which may also be referred to herein as NMOS attributes, relative to an influence of electrical and/or operational characteristics of a p-type metal-oxide-semiconductor (PMOS) device (e.g., a PMOS transistor), which may also be referred to herein as PMOS attributes. As another example, the second attributes of the second device 112 may be predominantly influenced by PMOS attributes relative to an influence of NMOS attributes.

In some implementations, the NMOS attributes and the PMOS attributes may refer to electrical and/or operational attributes of the NMOS device and/or the PMOS device, such as a voltage, a current, a resistance, an impedance, a capacitance, an inductance, a signal integrity, a frequency response, a transient response, a thermal behavior, and/or reliability metrics, among other examples, and/or other operational parameters associated with the NMOS device and/or the PMOS device.

For example, the NMOS attributes and/or the PMOS attributes may include a carrier type (e.g., an NMOS device may be configured to use electrons as charge carriers, while a PMOS device may be configured to use holes as charge carries), a threshold voltage (e.g., a minimum gate voltage required to switch the NMOS or PMOS device to an on state), a drive strength (e.g., a maximum current the NMOS or PMOS device may be configured to supply to drive a load), a power consumption (e.g., an amount of power consumed during operation), noise sensitivity (e.g., a susceptibility to signal fluctuations and/or external noise), switching behavior (e.g., a speed at which the NMOS or PMOS device may be configured to switch between on and off states), a subthreshold leakage (e.g., a current flowing when the NMOS or PMOS device is in an off state), and/or other operational parameters, such as a voltage, a current, a resistance, an impedance, a capacitance, an inductance, a signal integrity, a frequency response, a transient response, a thermal behavior, and/or reliability metrics, among other examples.

In some implementations, the first device 110 may be an NMOS device, may contain a greater number of NMOS devices than PMOS devices, and/or the first device 110 may be configured to operate with electrical and/or operational characteristics more strongly influenced by NMOS attributes than PMOS attributes. As another example, the second device 112 may be a PMOS device, may contain a greater number of PMOS devices than NMOS devices, and/or the second device 112 may be configured to operate with electrical and/or operational characteristics more strongly influenced by PMOS attributes than NMOS attributes.

In some implementations, the first device 110 and the second device 112 may be oscillator circuits (e.g., digital oscillator circuits, among other examples). For example, the first device 110 may be an NMOS-based ring oscillator having attributes primarily associated with NMOS attributes relative to PMOS attributes. As another example, the second device 112 may be a PMOS-based ring oscillator having attributes primarily associated with PMOS attributes relative to NMOS attributes.

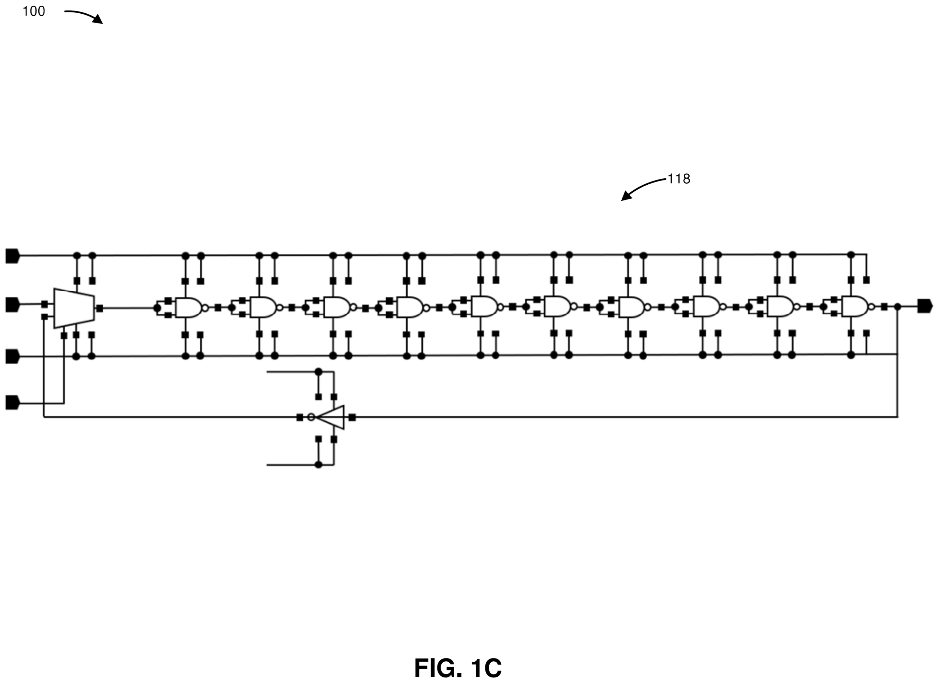

In some implementations, the first device 110 may be a not AND (NAND) ring oscillator array having attributes primarily associated with NMOS attributes relative to PMOS attributes. For example, and as shown in Fig. 1C, the first device 110 may be a multi-stage (e.g., a ten-stage) NAND ring oscillator circuit 118.

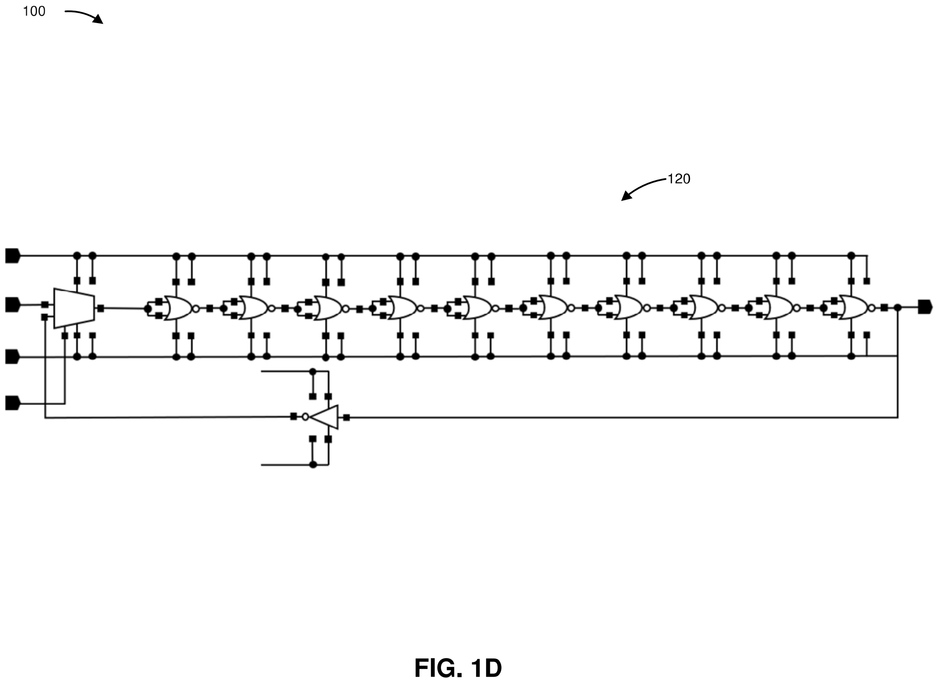

In some implementations, the second device 112 may be a not OR (NOR) ring oscillator array having attributes primarily associated with PMOS attributes relative to NMOS attributes. For example, and as shown in Fig. 1D, the second device 112 may be a multi-stage (e.g., a ten-stage) NOR ring oscillator circuit 120. Although particular configurations of the first device 110 and the second device 112 are described herein, the first device 110 and the second device 112 may be any suitable devices having any suitable attributes to allow the systems and methods described herein to be implemented.

Accordingly, and in some implementations, at least a portion of the first attributes of the first device 110 and the second attributes of the second device 112 may be differently affected by stress (e.g., stress associated with and/or affecting the region 104 at various points in time). Accordingly, and in some implementations, the first attributes of the first device 110 and the second attributes of the second device 112 may be representative of information corresponding to the region 104, such as stress measurement data associated with the region 104, as described in more detail elsewhere herein. For example, the stress measurement data associated with the region 104 may refer to quantitative and/or qualitative data representative of stress associated with the region 104 (e.g., stress applied to the region 104 and/or otherwise acting on the region 104, among other examples) of the substrate 102.

In some implementations, the stress measurement data may include values indicative of stress associated with the region 104 of the substrate 102 (e.g. stress measurement values indicative of the stress associated with the region 104 of the substrate), such as at one or more times of operation of the first device 110 and/or the second device 112 over a time period, among other examples. For example, the values may be indicative of one or more stress magnitudes (e.g., one or more levels or intensities of stress applied to the region 104, such as stress measured in pascals (Pa)), one or more stress directions (e.g., one or more orientations or vector directions of stress applied to the region 104, such as in-plane or out-of-plane stress directions), one or more stress types (e.g., one or more classifications of the stress applied to the region 104, such as compressive stress and/or tensile stress), one or more stress variabilities (e.g., one or more fluctuations or changes in stress magnitude levels over time), and/or one or more stress distributions (e.g., one or more spatial variations of stress applied to the region 104), among other examples.

In some implementations, the circuitry 114 may be configured to obtain attributes of the first device 110 and the second device 112, such as by measuring or using other data acquisition techniques. For example, the circuitry 114 may include one or more electrical components configured to operate the first device 110 and/or the second device, control the operation of the first device 110 and/or the second device 112, monitor a performance of the first device 110 and/or the second device 112, and/or obtain measurements of the attributes of the first device 110 and the second device 112, as described in more detail elsewhere herein.

For example, the circuitry 114 may include an interface (e.g., a Joint Test Action Group (JTAG) interface configured for debugging and performance testing), a memory (e.g., one-time programmable (OTP) memory configured for storing device configurations or calibration data), a voltage regulator (e.g., a circuit configured to regulate a voltage supplied to the first device 110 and/or the second device 112 to enhance an accuracy of the attributes), and/or a calibration circuit (e.g., configured to calibrate the first device 110 and/or the second device 112 to enhance an accuracy of the attributes, such as during a time in which the substrate 102 is part of the wafer 106), among other examples.

For example, the circuitry 114 may be configured to regulate a voltage supplied to the first device 110 and/or the second device 112 by controlling one or more voltage levels, such as within one or more thresholds. As another example, the circuitry 114 may be configured to calibrate the first device 110 and/or the second device 112 by adjusting (e.g., during a time in which the substrate 102 is part of the wafer 106) one or more operational settings of the first device 110 and/or the second device 112 to enhance the accuracy of the attributes of the first device 110 and/or the second device 112, among other examples.

In some implementations, the circuitry 114 may include a clock generation circuit (e.g., including a ring oscillator or a phase-locked loop (PLL) circuit), a signal conditioning circuit (e.g., including one or more amplifiers or filters), stress monitoring circuitry (e.g., circuits configured to measure variations between threshold voltages, switching speeds, and/or drive strengths of the first device 110 and/or the second device 112), and/or temperature sensors configured to detect temperatures associated with operation and/or monitoring of the first device 110 and/or the second device 112.

In some implementations, the circuitry 114 may be configured to measure the first attributes and the second attributes, such as during operation of the first device 110 and/or the second device 112 over a time period and/or under a set of operating parameters. For example, the circuitry 114 may be configured to measure the first attributes and/or the second attributes at an initial time of the time period, at a final time of the time period, and/or any point between the initial time and the final time, among other examples.

For example, and as shown in Fig. 1A, the circuitry 114 may be configured to measure the first attributes and the second attributes at a time in which the substrate 102 is part of the wafer 106 (e.g., shown as a first time in Fig. 1A) and at a time in which the substrate 102 is part of the package 108 (e.g., shown as a second time in Fig. 1A), among any other points in time. In some implementations, the first attributes and/or the second attributes (e.g., measured via the circuitry 114) may include carrier type information, threshold voltage information, drive strength information, power consumption information, noise sensitivity information, switching behavior information, subthreshold leakage information, and/or oscillation frequency information associated with the first device 110 and the second device 112, among other examples.

Accordingly, for example, the circuitry 114 may be configured to obtain carrier type measurements (e.g., voltage and/or current measurements), threshold voltage measurements, drive strength measurements, power consumption measurements, noise sensitivity measurements, switching behavior measurements (e.g., switching speed measurements), subthreshold leakage measurements, and/or oscillation frequency measurements, among other examples.

In some implementations, the circuitry 114 may be configured to measure the first attributes and the second attributes individually, or in combination, to assess an overall performance of the first device 110 and the second device 112 (e.g., at one or more times), among other examples. In some implementations, the circuitry 114 may be configured to perform gate voltage sweeps and measure currents (e.g., in linear regions and saturation regions) to obtain threshold voltages and drive strengths of the first device 110 and/or the second device 112.

As another example, the circuitry 114 may be configured to monitor current draw, noise response, switching transitions, and/or leakage currents (e.g., under varying conditions) to measure power consumption, noise sensitivity, switching speed, and/or subthreshold leakage, among other examples. As yet another example, the circuitry 114 may be configured to measure frequencies (e.g., oscillation frequencies) of the first device 110 and/or the second device 112 (e.g., when the first device 110 and/or the second device 112 are implemented as oscillator circuits, among other examples).

In some implementations, the circuitry 114 may be configured to differentially measure the first attributes and the second attributes. For example, the circuitry 114 may be configured to measure one or more differences between the first attributes and the second attributes. In this way, the data processing system 116 may evaluate the differences between the first attributes and the second attributes, such as to determine relative performances between the first device 110 and/or the second device 112 and/or to detect trends in the performance of the first device 110 and/or the second device 112, among other examples. Accordingly, and in some implementations, the first attributes and the second attributes (e.g., obtained via the circuitry 114) may include differential measurements, which may be processed (e.g., to determine differences between the first attributes and the second attributes, among other examples).

Accordingly, the first attributes may be indicative of a performance of the first device 110 and the second attributes may be indicative of a performance of the second device 112. In some implementations, stress affecting the first device 110 and the second device 112 (e.g., stress associated with the region 104 and/or applied to the region 104) may have different effects on the performance of the first device 110 relative to the performance of the second device 112 (e.g., based on the first device 110 being associated with NMOS attributes and the second device 112 being associated with PMOS attributes).

For example, and if compressive stress is applied to the region 104, the performance of the first device 110 may degrade (e.g., because compressive stress degrades a performance of an NMOS device), while the performance of the second device 112 may enhance (e.g., because compressive stress enhances a performance of a PMOS device). As another example, and if tensile stress is applied at the region 104, the performance of the first device 110 may enhance (e.g., because tensile stress enhances a performance of an NMOS device), while the performance of the second device 112 may degrade (e.g., because tensile stress degrades a performance of a PMOS device). In this way, changes in the performance of the first device 110 and the second device 112 may be indicative of stresses affecting the region 104 (e.g., localized stress associated with the region 104), as described in more detail elsewhere herein.

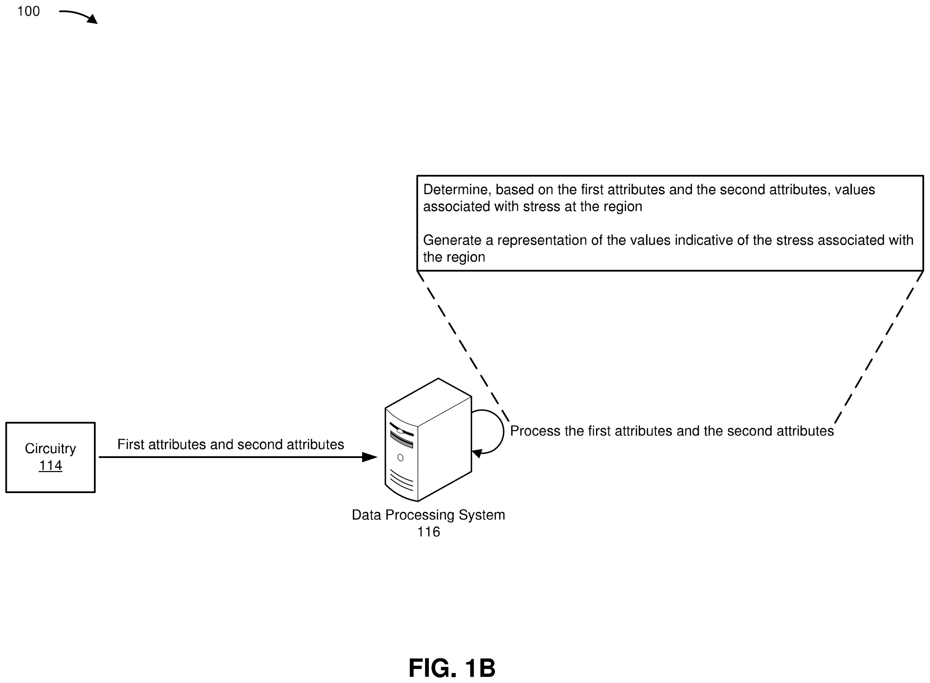

As shown in Fig. 1B, the circuitry 114 may be configured to provide an indication of the first attributes and the second attributes to the data processing system 116. The data processing system 116 may be configured to process the first attributes and the second attributes, as described in more detail elsewhere herein.

In some implementations, the data processing system 116 may be configured to evaluate the first attributes and the second attributes to determine the performance of the first device 110 and/or the second device 112 during the operation over the time period and/or under the set of operating conditions. For example, the data processing system 116 may be configured to detect changes in the performance of the first device 110 and/or the second device 112 at one or more times associated with the time period (e.g., changes in the performance of the first device 110 and/or the second device 112 at a time in which the substrate 102 is part of the wafer 106 and at a time in which the substrate 102 is part of the package 108, among other examples).

In some implementations, the attributes may include shifts caused by the stress associated with the region 104. For example, the first attributes and/or the second attributes may include shifts in a threshold voltage of the first device 110 and/or the second device 112. Accordingly, and if the first attributes and/or the second attributes include shifts caused by the stress associated with the region 104, the data processing system 116 may detect the changes in the performance of the first device 110 and/or the second device 112 based on the shifts, among other examples.

In some implementations, the data processing system 116 may be configured to establish baseline performance data (e.g., at an initial time of the time period) indicative of a baseline performance of the first device 110 and/or the second device 112 and/or subsequent performance data (e.g., from the initial time to a final time of the time period, or at any point between the initial time and the final time) indicative of a subsequent performance of the first device 110 and/or the second device 112.

In some implementations, the data processing system 116 may classify the changes in the performance of the first device 110 and/or the second device 112 at one or more times associated with the time period and/or under the set of operating conditions as enhanced performance, degraded performance, and/or stabilized performance. For example, enhanced performance may refer to an improvement in the performance of the first device 110 and/or the second device 112 at one or more times associated with the time period. For example, one or more attributes, included in the first attributes and/or the second attributes, measured at one or more times associated with the time period may be indicative of the improvement (e.g., an increase in threshold voltage being indictive of an increase in drive current), among other examples.

As an example, degraded performance may refer to a decline (or degradation) in the performance of the first device 110 and/or the second device 112 at one or more times associated with the time period. For example, one or more attributes, included in the first attributes and/or the second attributes, measured at one or more times associated with the time period may be indicative of the degradation (e.g., a decrease in threshold voltage being indicative of a decrease in drive current), among other examples.

As another example, stabilized performance may refer to the performance of the first device 110 and/or the second device 112 remaining at least one of stable, or substantially stable, at one or more times associated with the time period. For example, one or more attributes, included in the first attributes and/or the second attributes, measured at one or more times associated with the time period may be indicative of the performance of the first device 110 and/or the second device 112 remaining at least one of stable, or substantially stable (e.g., a threshold voltage remaining at least one of stable, or substantially stable, being indicative of a drive current that remains at least one of stable, or substantially stable), among other examples.

In some implementations, the data processing system 116 may be configured to determine stress measurement data (e.g., values indicative of the stress associated with the region 104) based on whether the changes in the performance of the first device 110 and/or the second device 112 (e.g., at one or more times associated with the time period and/or under the set of operating conditions) are classified as being enhanced performances, degraded performances, and/or stabilized performances, as described in more detail elsewhere herein.

For example, if a first set of changes in the performance of the first device 110 and/or the second device 112 (e.g., associated with a first time in the period) results in degraded performance of the first device 110 (e.g., due to an increase in the threshold voltage of the first device 110, which negatively affects switching speed and drive strength of the first device 110) and enhanced performance of the second device 112 (e.g., due to a decrease in the threshold voltage of the second device 112, which improves switching speed and drive strength of the second device 112), the data processing system 116 may be configured to determine that compressive stress affected the region 104 at the first time.

As another example, and if a second set of changes in the performance of the first device 110 and/or the second device 112 (e.g., at a second time in the time period) leads to enhanced performance of the first device 110 (e.g., due to a decrease in the threshold voltage of the first device 110, which improves switching speed and drive strength of the first device 110) and degraded performance of the second device 112 (e.g., due to an increase in the threshold voltage of the second device 112, which negatively affects switching speed and drive strength of the second device 112), the data processing system 116 may be configured to determine that tensile stress affected the region 104 at the second time.

Accordingly, and in some implementations, the data processing system 116 may be configured to measure stress by analyzing various attributes of the first device 110 (e.g., an NMOS device) and/or the second device 112 (e.g., a PMOS device), such as the first attributes and/or the second attributes. For example, the data processing system 116 may be configured to analyze threshold voltages, switching speeds, and/or drive strengths, among other examples, associated with the first device 110 and/or the second device 112.

For example, compressive stress may increase the threshold voltage in the first device 110, degrading performance, while tensile stress decreases the threshold voltage in the first device 110, enhancing performance. As another example, compressive stress may reduce the threshold voltage in the second device 112, enhancing performance, while tensile stress may increase the threshold voltage in the second device 112, degrading performance.

In some implementations, the data processing system 116 may be configured to monitor switching behavior (e.g., a switching speed of transistors included in the first device 110 and/or transistors included in the second device 112). Compressive stress may degrade performance (e.g., reduce switching speed) of the first device 110 and tensile stress may enhance performance (e.g., increase switching speed) of the first device 110. Compressive stress may enhance performance (e.g., increase switching speed) of the second device 112 and tensile stress may degrade performance (e.g., decrease switching speed) of the second device 112.

In some implementations, the data processing system 116 may be configured to monitor the drive strength of the first device 110 and/or the second device 112. Compressive stress may degrade performance (e.g., reduces drive strength) of the first device 110 and tensile stress may enhance performance (e.g., increases drive strength) of the first device 110. Compressive stress may enhance performance (e.g., increases drive strength) of the second device 112 and tensile stress may degrade performance (e.g., decreases drive strength switching speed).

In some implementations, the data processing system 116 may be configured to compare changes in the threshold voltages, the switching behavior, and/or the drive strengths of the first device 110 and/or the second device 112, among other examples, to determine stress measurement data representative of stress associated with the region 104 (e.g., stress affecting the region 104). For example, the data processing system 116 may be configured to compare the changes in the threshold voltages, the switching behavior, and/or the drive strengths of the first device 110 and/or the second device 112 and the baseline performance data of the first device 110 and/or the second device 112 to estimate the values (e.g., stress measurement data and/or stress measurement values) indicative of stress affecting the region 104, among other examples.

In some implementations, the data processing system 116 may be configured to determine a magnitude of stress, such as by quantifying the performance changes of the first device 110 and/or the second device 112. For example, the data processing system 116 may be configured to compare the changes in the performance in the first device 110 and/or the second device 112 with the baseline performance data and/or other baseline data to estimate a magnitude of the stress affecting the region 104.

In some implementations, the data processing system 116 may be configured to adjust, based on at least one of the values or the representation, one or more parameters creating adjusted one or more parameters, to modify how the stress interacts with a subsequent region of a subsequent substrate formed based on the adjusted one or more parameters. For example, the data processing system 116 may be configured to modify one or more processes for forming a subsequent substrate having a subsequent region that at least one of matches, or substantially matches, the region 104, based on one or more parameters that influence stress associated with the region 104, as described in more detail elsewhere herein.

In some implementations, the one or more parameters may include one or more process parameters, design parameters, and/or material parameters, among other examples. For example, the one or more process parameters may include deposition (e.g., adjusting film thickness or temperature to reduce residual stress), etching (e.g., modifying depth or rate to minimize stress concentrations), doping (e.g., controlling ion implantation to manage threshold voltage shifts), annealing (e.g., optimizing thermal cycles to relieve internal stress), and/or dicing (e.g., adjusting cutting methods to reduce mechanical stress) parameters, among other examples.

As another example, the one or more design parameters may include layer thickness (e.g., modifying oxide/metal layers for stress balance), feature dimension (e.g., optimizing transistor/interconnect geometry), interconnect layout (e.g., adjusting routing to reduce stress-induced resistance changes), and/or substrate orientation (e.g., selecting crystal orientation for stress response) parameters, among other examples.

As yet another example, the one or more material parameters may include material composition (e.g., altering insulating/conductive materials for stress tolerance), thermal expansion property (e.g., selecting materials with matched coefficients of thermal expansion (CTE)), and/or mechanical stress tolerance (e.g., using stress-buffering materials to minimize localized stress) parameters, among other examples.

In some implementations, the data processing system 116 may be configured to generate a representation (e.g., a map, among other examples) of values indicative of stress associated with the region 104. For example, the representation may include indications of the values representative of one or more stresses associated with the region 104 (e.g., affecting the region 104 and/or applied to the region 104), such as one or more stress magnitudes, stress directions, stress types, stress variabilities, and/or stress distributions (e.g., at one or more times of a time period) affecting the region 104. In some implementations, the values may be depicted spatially and/or temporally, indicating how the one or more stresses affects the region 104, such as at different points in time and locations of the region 104.

In some implementations, the data processing system 116 may be configured to adjust, based on at least one of the values or the representation, the one or more parameters, creating adjusted one or more parameters, to modify how stress interacts with the region 104 and/or to modify how stress interacts with a subsequent region of a subsequent substrate, as described in more detail elsewhere herein.

In some implementations, the representation may be indicative of a progression of one or more stresses that have affected the region 104 (e.g., the representation may represent an evolution of one or more stresses affecting the region 104). For example, the progression may indicate values at multiple times, such as a time in which the substrate 102 was a part of the wafer 106 to a time in which the substrate 102 was part of the package 108, among other examples.

As an example, the progression may indicate a first set of values indicative of a first stress affecting the region 104 at a first time when the substrate 102 was a part of the wafer 106 and subjected to a wafer fabrication process. The data processing system 116 may be configured to determine, based on the first values and the wafer fabrication process, to adjust the wafer fabrication process, creating a modified wafer fabrication process, to modify how the first stress may affect a subsequent region of a subsequent substrate (e.g., the first stress may not affect the subsequent region based on being formed using the modified wafer fabrication process).

As another example, the progression may indicate a second set of values indicative of a second stress affecting the region 104 at a second time when the substrate 102 was subjected to a thermal energy. The data processing system 116 may be configured to determine, based on the second set of values, a material composition of the region 104 of the substrate 102, and the thermal energy, to adjust the material composition of the region 104 to an adjusted material composition to modify how the second set of values may affect a subsequent region (e.g., the second stress may not affect the subsequent region based on being formed with the adjusted material composition) of the subsequent substrate.

As yet another example, the progression may indicate a third set of values indicative of a third stress affecting the region 104 at a third time when the substrate 102 was a part of the package 108 and subjected to a packaging process. The data processing system 116 may be configured to determine, based on the third set of values and the packaging process, to request for the region 104 of the substrate 102 to be inspected. For example, the third set of values may indicate stress magnitudes of the third stress affecting the region 104 at the third time, and the data processing system 116 may be configured to request, based on the stress magnitudes satisfying a threshold (e.g., based on the stress magnitudes exceeding a stress magnitude threshold), to request for the region 104 of the substrate to be inspected.

In some implementations, the data processing system 116 may be configured to classify, based on at least one of the values or the representation, the substrate 102 into a category. In some implementations, the category may be associated with a stress tolerance of the region 104, a stress tolerance of the substrate 102, and/or adjustments associated with the one or more parameters, among other examples.

In some implementations, the data processing system 116 may be configured to determine a confidence score indicative of a likelihood of failure to occur at the region 104 of the substrate 102. For example, the data processing system may provide the values and/or the representation as an input to one or more machine learning models trained to output the confidence score indicative of the likelihood of the failure to occur at the region 104 of the substrate 102. The data processing system 116 may receive an indication of the confidence score as an output provided by the one or more machine learning models.

In some implementations, the data processing system 116 may be configured to perform a first action based on the confidence score satisfying a first threshold (e.g., the data processing system 116 may be configured to trigger a request for the region 104 to be inspected, among other examples) and may be configured to perform a second action based on the confidence score satisfying a second threshold (e.g., the data processing system 116 may be configured to refrain from triggering a request for the region 104 to be inspected, among other examples).

As another example, the data processing system 116 may be configured to perform a first action based on the confidence score satisfying a threshold (e.g., the data processing system 116 may be configured to classify the substrate 102 into a first category associated with a higher risk of failure at the region 104 than a second category based on the confidence score satisfying the threshold, among other examples. Accordingly, and in some implementations, the data processing system 116 may be configured to classify the substrate 102 into any suitable category based on analyzing the stress associated with the region 104.

In some implementations, the data processing system 116 may be configured to determine, based on at least one of the values or the representation, a predicted time of failure for the region 104. For example, the data processing system may provide the values and/or the representation as an input to one or more machine learning models trained to output the predicted time of failure for the region. The data processing system 116 may receive an indication of the predicted time of failure for the region 104 as an output provided by the one or more machine learning models.

In some implementations, the data processing system 116 may be configured to perform a first action based on the predicted time of failure for the region satisfying a first threshold (e.g., the data processing system 116 may be configured to trigger a request for the substrate 102 to be withheld from being operationally deployed, among other examples) and may be configured to perform a second action based on the predicted time of failure of the region 104 satisfying a second threshold (e.g., the data processing system 116 may be configured to refrain from triggering a request for the substrate 102 to be withheld from being operationally deployed, among other examples).

Although the first device 110 and the second device 112 are shown and described as being configured to operate at a location associated with the region 104, any suitable number of devices (e.g., any suitable number of NMOS and PMOS devices) may be configured to operate at any suitable number of locations associated with any suitable number of regions of any suitable number of substrates. For example, the first device 110 and the second device 112 may be implemented as a paired circuit (e.g., sharing one or more common electrical components, such as a common voltage regulator and/or a common power distribution network), such as an NMOS-based ring oscillator and a PMOS-based ring oscillator pair and/or a NAND ring oscillator array and a NOR ring oscillator array pair, among other examples) operating at a location in proximity to the region 104, among other examples.

Although the first device 110 and the second device 112 are described as being positioned at a location associated with the region 104 (e.g., a location corresponding to the region 104), any suitable number devices (e.g., having at least a portion of attributes that are differently affected by stress) may be positioned at locations associated with any suitable number of regions of a substrate. As another example, the first device 110 and the second device 112 may be implemented as a single device (e.g., a single electrical circuit having at least a portion of attributes that are differently affected by stress), among other examples. In this way, some implementations described herein may be configured to determine stress measurement data (e.g., associated with any suitable number of values indicative of any suitable number of stresses associated with any suitable number of corresponding regions).

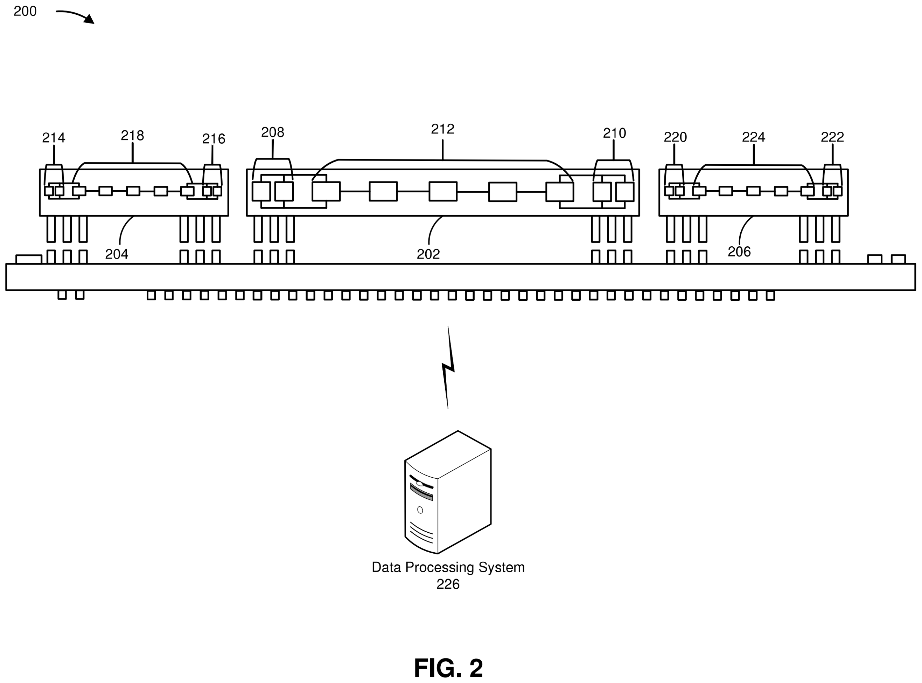

Fig. 2 is a diagram of an example 200 associated with enhanced stress evaluation associated with a semiconductor device. As shown in Fig. 2, the example 200 may include a first semiconductor device 202 (e.g., shown in cross-section), a second semiconductor device 204 (e.g., shown in cross-section), and a third semiconductor device 206 (e.g., shown in cross-section). The first semiconductor device 202 may include a first pair of devices 208 (e.g., associated with a first region), a second pair of devices 210 (e.g., associated with a second region), and first circuitry 212. The second semiconductor device 204 may include a third pair of devices 214 (e.g., associated with a third region), a fourth pair of devices 216 (e.g., associated with a fourth region), and second circuitry 218. The third semiconductor device 206 may include a fifth pair of devices 220 (e.g., associated with a fifth region), a sixth pair of devices 222 (e.g., associated with a sixth region), and third circuitry 224. As further shown in Fig. 2, the example 200 may include a data processing system 226.

In some implementations, the first pair of devices 208, the second pair of devices 210, the third pair of devices 214, the fourth pair of devices 216, the fifth pair of device 220, and the sixth pair of devices 222 may each include a first device (e.g., which may correspond to the first device 110 shown and described in connection with Figs. 1A-1D) and a second device (e.g., which may correspond to the second device 112 shown and described in connection with Figs. 1A-1D). In some implementations, the first circuitry 212, the second circuitry 218 and the third circuitry 224 may correspond to the circuitry 114 shown and described in connection with Figs. 1A-1D.

Accordingly, and in some implementations, the first circuitry 212 may be configured to obtain attributes (e.g., first attributes and second attributes) of the first pair of devices 208 and/or the second pair of devices 210, the second circuitry 218 may be configured to obtain attributes (e.g., first attributes and second attributes) of the third pair of devices 214 and/or the fourth pair of devices 216, and/or the third circuitry 224 may be configured to obtain attributes (e.g., first attributes and second attributes) of the fifth pair of devices 220 and/or the sixth pair of devices 222. The first circuitry 212, the second circuitry 218, and/or the third circuitry 224 may provide the performance characteristic to the data processing system 226 (e.g., which may correspond to the data processing system shown and described in connection with Figs. 1A-1D). Accordingly, and in some implementations, the data processing system 226 may process the attributes to determine stress measurement data, as described in more detail elsewhere herein. For example, the data processing system 226 may be configured to determine values associated with stress at first region, the second region, the third region, the fourth region, the fifth region, and/or the sixth region, among other examples.

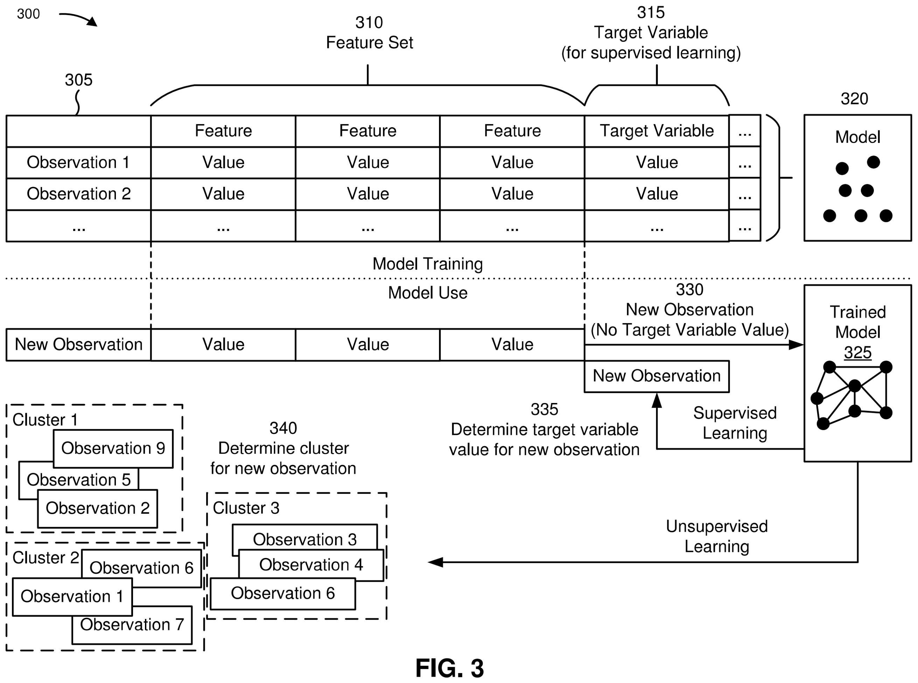

Fig. 3 is a diagram illustrating an example 300 of training and using a machine learning model in connection with enhanced stress evaluation associated with a semiconductor device. The machine learning model training and usage described herein may be performed using a machine learning system. The machine learning system may include, or may be included in, circuitry configured by execution of software instructions to perform the disclosed operations and/or previously configured to perform the disclosed operations (e.g., an application-specific IC (ASIC) and/or a programmable array logic (PAL), among other examples).

Moreover, the circuitry may be embodied in various forms such as one or more of a processor, a controller, an ASIC or PAL, a computer, a server, and/or a cloud computing environment, among other examples, such as a data processing system (e.g., the data processing system 116 and/or the data processing system 226) described in more detail elsewhere herein. In some implementations, the circuitry may be integrated with a sensor in a composite structure such that the circuitry is configured to perform operations on data provided by the sensor, or the circuitry may be physically separated from the sensor. Moreover, the circuitry may be distributed as multiple circuits that exchange data via a wired bus or wirelessly.

A portion of the training dataset includes a set of observations 305. The set of observations 305 may include data structures populated with training data, such as attributes of devices where at least a portion of the attributes are differently affected by stress (e.g., the first attributes of the first device 110 and/or the second attributes of the second device 112, among other examples) operating at a location associated with a region of a substrate (e.g., the region 104 of the substrate 102), such as under different stress conditions, a feature set 310, and target variables 315. The training data may be labeled or unlabeled and may be gathered during various processes and/or operations (e.g., one or more wafer fabrication processes, dicing processes, packaging processes, and/or operations in a packaged device, among other examples). The machine learning system may be configured to receive the set of observations 305 from various sources, such as circuitry (e.g., the circuitry 114, the first circuitry 212, the second circuitry 218, and/or the third circuitry 224, the data processing system 116, and/or the data processing system 226, among other examples), semiconductor test equipment, wafer inspection systems, stress monitoring circuitry, and/or simulation models, among other examples.

The feature set 310 may include a set of variables, where each variable represents a characteristic relevant to stress analysis (e.g., the first attributes of the first device 110 and/or the second attributes of the second device 112). The machine learning system may be configured to determine variables for a particular set of observations from various sources, such as test structures embedded in wafers, test structures embedded in packages, ring oscillators, and/or integrated stress sensors, among other examples. For example, the machine learning system may be configured to extract the feature set from structured data, perform signal processing on time-series data, and/or receive inputs from an operator.

As an example, a particular feature set for a set of observations may include threshold voltage shifts (e.g., variations in threshold voltage due to applied stresses) indicated by the attributes, switching speed changes (e.g., how compressive or tensile stress impacts transistor switching time) indicated by the attributes, and/or drive strength variations (e.g., degradation or enhancement in current-driving capability due to mechanical strain) indicated by the attributes, among other examples. For a first observation, a threshold voltage shift may indicate an increase or decrease in a threshold voltage, a switching speed change may indicate an acceleration or a deceleration in a switching speed, and a drive strength variation may indicate an increase or decrease in an ability to drive current, among other examples. The feature set may also include other variables, such as carrier mobility variations, leakage current changes, and/or stress distributions, among other examples.

Each observation in the set of observations 305 may be associated with a target variable 315. The target variable 315 may be a numerical value, a classification, or a Boolean variable. For example, the target variable may indicate a confidence score indicative of a likelihood of failure to occur at a region of a substrate (e.g., the region 104 of the substrate 102) and/or a predicted time of failure for a region of a substrate (e.g., the region 104 of the substrate 102). For example, the machine learning model may be configured to trigger, based on the confidence score satisfying a first threshold), a request for the substrate 102 and/or the region 104 to be inspected. As another example, the machine learning model may be configured to refrain from triggering, based on the confidence score satisfying a second threshold, a request for the substrate 102 and/or the region 104 to be inspected.

As another example, the target variable may indicate a recommended adjustment (e.g., to one or more parameters associated with the stress affecting the region of the substrate) to modify how a stress affecting the region affects a subsequent region of a subsequent substrate. For example, the recommended adjustment may indicate an adjustment to a material of the subsequent region that reduces effects of the stress at the subsequent region relative to how the stress affected the region.

As another example, the target variable may represent a predicted stress magnitude of stress affecting a region, a predicted stress direction of a stress affecting the region, a predicted stress type of a stress affecting the region, a predicted stress variation of a stress affecting the region, and/or a predicted stress distribution of a stress affecting the region, among other examples.

The target variable may represent a value that the machine learning model is trained to predict. The feature set may represent the input variables used to predict the target variable value. The training data may allow the machine learning model to recognize patterns in the feature set that lead to specific stress conditions. If labeled data is available, the model may be trained as a supervised learning model.

In some implementations, the machine learning model may be trained on unlabeled data, using unsupervised learning to identify stress-related patterns without predefined labels. This may involve clustering attributes of devices with similar performance enhancement profiles and/or performance degradation profiles and/or or identifying anomalies in stress distribution, among other examples.

The machine learning system may be configured to train a machine learning model 320 using the set of observations 305 and one or more machine learning algorithms, such as a regression model, decision tree, neural network, k-nearest neighbor algorithm, or support vector machine. After training, the system may be configured to store the trained machine learning model 325 for analyzing new observations. The trained machine learning model 325 may be implemented as a convolutional neural network (CNN) trained to detect stress-related performance deviations.

As an example, the machine learning system may be configured to obtain training data for stress analysis based on historical stress measurements (e.g., at the region 104 of the substrate 102) from semiconductor test structures, performance degradation trends over time, and/or failure analysis reports, among other examples.

The trained machine learning model 325 may be applied to a new observation 330, such as by receiving new performance data and inputting it into the model. The new observation 330 may include a threshold voltage shift indicative of a stress-induced shift, a switching speed change indicative of an impact from applied stress, and/or a drive strength variation indicative of mechanical strain, among other examples. By applying the trained machine learning model 325 to the new observation 330, the system may be configured to generate an output, such as a confidence score indicative of a likelihood of failure to occur at the region of the substrate, a predicted time of failure for the region of the substrate, a recommended adjustment (e.g., to one or more parameters associated with the stress affecting the region of the substrate), a predicted measurement value, and/or a predicted stress tolerance category, among other examples.

For example, the trained machine learning model 325 may be configured to predict a value (e.g., indicative of stress at a region of a substrate), such as a stress magnitude for the target variable 335 of stress in the region of the substrate (e.g., the region 104 of the substrate), based on the observed feature values. Based on this prediction, the system may be configured to recommend adjustments to one or more parameters, such as one or more process parameters, design parameters, and/or material parameters, as described in more detail elsewhere herein.

In some implementations, the trained machine learning model 325 may be configured to monitor an evolution of stress at a region (e.g., from a time in which the substrate 102 is part of the wafer 106 to a time in which the substrate 102 is part of the package 108) and may recommend screening if a threshold is exceeded (e.g., to prevent components susceptible to stress-induced failure from being commercially released, among other examples).

In some implementations, the trained machine learning model 325 may be configured to classify the new observation into a cluster 340. For example, the trained machine learning model may be configured to classify the new observation into a into a stress tolerance category (e.g., a low-stress tolerance category and/or a high-stress tolerance category, among other examples). Observations in a cluster may exhibit similar stress responses. For example, if historical records indicate that devices with a similar threshold voltage shift pattern experience reliability issues in the field, then the system may be configured to flag the device for additional screening.

If the model classifies the new observation in a low-stress cluster, it may allow normal processing. If classified in a high-stress cluster, the system may recommend process modifications (e.g., optimizing packaging conditions). The system may be configured to base recommendations and actions on target variable thresholds. For example, if the value satisfies a threshold, the system may be configured to trigger re-evaluation of a wafer fabrication process or trigger additional testing for failure at the region of the substrate (e.g., the region 104 of the substrate 102).

The trained machine learning model 325 may also be re-trained using feedback. For example, the system may be configured to refine predictions based on actual failure rates observed in the field. If a model prediction led to an unnecessary process change, the system may be configured to adjust its decision thresholds accordingly. In this way, the machine learning system may be configured to apply a rigorous, automated process to enhanced stress evaluation associated with a semiconductor device. The system may be configured to predict a failure time of regions based on observed stress levels, improving identification of potential failure points. The system may be configured to analyze millions of data points with greater accuracy and efficiency than manual stress assessments, reducing variability and improving semiconductor device reliability.

As indicated above, Fig. 3 is provided as an example. Other examples may differ from what is described in connection with Fig. 3.

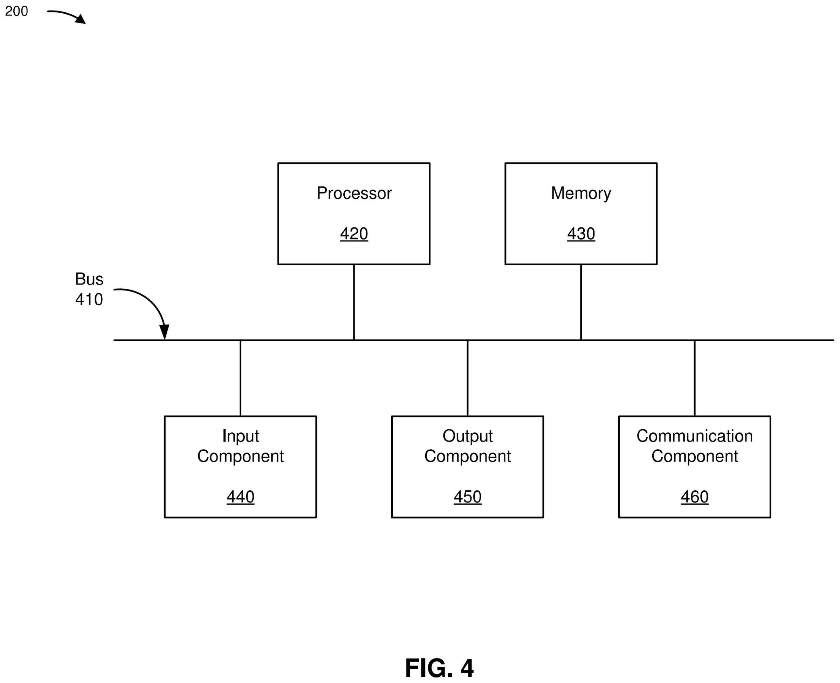

Fig. 4 is a diagram of example components of a device 400 associated with enhanced stress evaluation associated with a semiconductor device. The device 400 may correspond to the circuitry 114, the data processing system 116, the first circuitry 212, the second circuitry 218, the third circuitry 224, and/or the data processing system 226. In some implementations, the circuitry 114, the data processing system 116, the first circuitry 212, the second circuitry 218, the third circuitry 224, and/or the data processing system 226 may include one or more devices 400 and/or one or more components of the device 400. As shown in Fig. 4, the device 400 may include a bus 410, a processor 420, a memory 430, an input component 440, an output component 450, and/or a communication component 460.

The bus 410 may include one or more components that enable wired and/or wireless communication among the components of the device 400. The bus 410 may couple together two or more components of Fig. 4, such as via operative coupling, communicative coupling, electronic coupling, and/or electric coupling. For example, the bus 410 may include an electrical connection (e.g., a wire, a trace, and/or a lead) and/or a wireless bus. The processor 420 may include a central processing unit, a graphics processing unit, a microprocessor, a controller, a microcontroller, a digital signal processor, a field-programmable gate array, an ASIC, and/or another type of processing component. The processor 420 may be implemented in hardware, firmware, or a combination of hardware and software. In some implementations, the processor 420 may include one or more processors capable of being programmed to perform one or more operations or processes described elsewhere herein.

The memory 430 may include volatile and/or nonvolatile memory. For example, the memory 430 may include random access memory (RAM), read only memory (ROM), a hard disk drive, and/or another type of memory (e.g., a flash memory, a magnetic memory, and/or an optical memory). The memory 430 may include internal memory (e.g., RAM, ROM, or a hard disk drive) and/or removable memory (e.g., removable via a universal serial bus connection). The memory 430 may be a non-transitory computer-readable medium. The memory 430 may store information, one or more instructions, and/or software (e.g., one or more software applications) related to the operation of the device 400. In some implementations, the memory 430 may include one or more memories that are coupled (e.g., communicatively coupled) to one or more processors (e.g., processor 420), such as via the bus 410. Communicative coupling between a processor 420 and a memory 430 may enable the processor 420 to read and/or process information stored in the memory 430 and/or to store information in the memory 430.

The input component 440 may enable the device 400 to receive input, such as user input and/or sensed input. For example, the input component 440 may include a touch screen, a keyboard, a keypad, a mouse, a button, a microphone, a switch, a sensor, a global positioning system sensor, a global navigation satellite system sensor, an accelerometer, a gyroscope, and/or an actuator. The output component 450 may enable the device 400 to provide output, such as via a display, a speaker, and/or a light-emitting diode. The communication component 460 may enable the device 400 to communicate with other devices via a wired connection and/or a wireless connection. For example, the communication component 460 may include a receiver, a transmitter, a transceiver, a modem, a network interface card, and/or an antenna.

The device 400 may perform one or more operations or processes described herein. For example, a non-transitory computer-readable medium (e.g., memory 430) may store a set of instructions (e.g., one or more instructions or code) for execution by the processor 420. The processor 420 may execute the set of instructions to perform one or more operations or processes described herein. In some implementations, execution of the set of instructions, by one or more processors 420, causes the one or more processors 420 and/or the device 400 to perform one or more operations or processes described herein. In some implementations, hardwired circuitry may be used instead of or in combination with the instructions to perform one or more operations or processes described herein. Additionally, or alternatively, the processor 420 may be configured to perform one or more operations or processes described herein. Thus, implementations described herein are not limited to any specific combination of hardware circuitry and software.

The number and arrangement of components shown in Fig. 4 are provided as an example. The device 400 may include additional components, fewer components, different components, or differently arranged components than those shown in Fig. 4. Additionally, or alternatively, a set of components (e.g., one or more components) of the device 400 may perform one or more functions described as being performed by another set of components of the device 400.

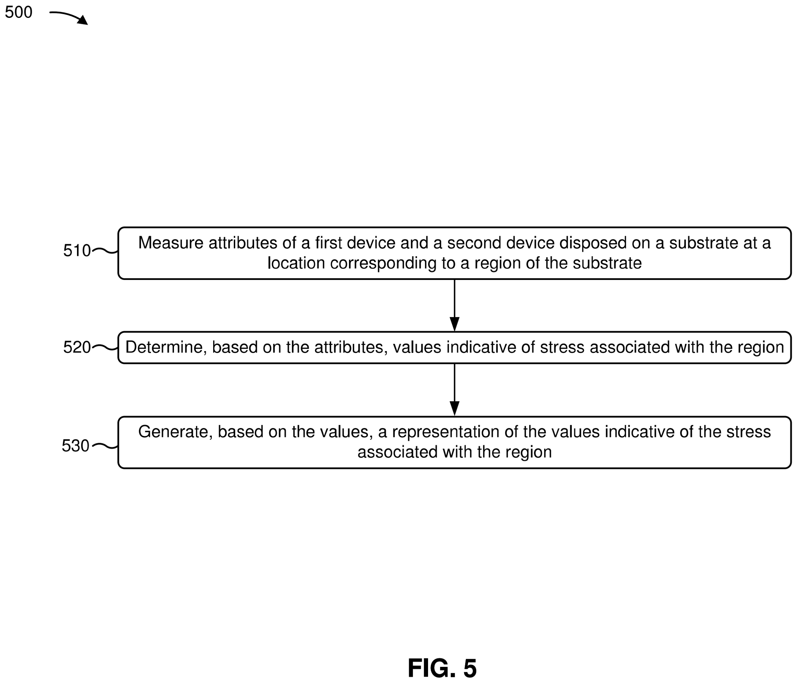

Fig. 5 is a flowchart of an example process 500 associated with enhanced stress evaluation associated with a semiconductor device. In some implementations, one or more process blocks of Fig. 5 may be performed by circuitry (e.g., the circuitry 114, the first circuitry 212, the second circuitry 218, and/or the third circuitry 224) and/or a data processing system (e.g., the data processing system 116 and/or the data processing system 226). In some implementations, one or more process blocks of Fig. 5 may be performed by another device, or a group of devices separate from or including the data processing system, such as circuitry (e.g., the circuitry 114, the first circuitry 212, the second circuitry 218, and/or the third circuitry 224).

As shown in Fig. 5, the process 500 may include measuring attributes of a first device and a second device disposed on a substrate at a location corresponding to a region of the substrate (block 510). For example, the circuitry may measure attributes of a first device and a second device disposed on a substrate at a location corresponding to a region of the substrate, as described in more detail elsewhere herein. In some implementations, at least a portion of the attributes of the first device and the second device may be differently affected by stress.

As further shown in Fig. 5, the process 500 may include determining, based on the attributes, values indicative of stress associated with the region (block 520). For example, the data processing system may determine, based on the attributes, values indicative of stress associated with the region, as described in more detail elsewhere herein.

As further shown in Fig. 5, the process 500 may include generating, based on the values, a representation of the values indicative of the stress associated with the region (block 530). For example, the data processing system may generate, based on the values, a representation of the values indicative of the stress associated with the region, as described in more detail elsewhere herein.

Although Fig. 5 shows example blocks of the process 500, in some implementations, the process 500 may include additional blocks, fewer blocks, different blocks, or differently arranged blocks than those depicted in Fig. 5. Additionally, or alternatively, two or more of the blocks of the process 500 may be performed in parallel. The process 500 is an example of one process that may be performed by one or more devices described herein. These one or more devices may be configured to perform one or more other processes based on operations described herein, such as the operations described in connection with Figs. 1A-1D, Fig. 2, and Fig. 3. Moreover, while the process 500 has been described in relation to the devices and components of the preceding figures, the process 500 can be performed using alternative, additional, or fewer devices and/or components. Thus, the process 500 is not limited to being performed with the example devices, components, hardware, and software explicitly enumerated in the preceding figures.

Additionally, the functionality of the elements described herein may be implemented using circuitry or processing circuitry, including general-purpose processors, special-purpose processors, ICs, ASICs, conventional circuitry, or combinations thereof, configured or programmed to perform the disclosed functionality. A processor is a type of processing circuitry, as it includes transistors and other physical circuit components. A processor may execute instructions stored in a memory, thereby operating as a programmed processor. In this disclosure, the terms "circuitry," "units," or "means" refer to hardware that performs, or is programmed to perform, the described functionality. Such hardware may include any disclosed hardware or other known hardware that is configured or programmed to execute the described functions. When the hardware includes a processor, which is a type of circuitry, the circuitry, means, or units refer to a combination of hardware and software, where the software configures the hardware and/or processor to perform the specified functions.

Even though particular combinations of features are recited in the claims and/or described in this disclosure, these combinations are not intended to limit the disclosure of various implementations. In fact, many of these features may be combined in ways not specifically recited in the claims and/or described in this disclosure. Although each dependent claim listed below may directly depend on only one claim, the disclosure of various implementations includes each dependent claim in combination with every other claim in the claim set.

When an element is referred to herein as being "connected" or "coupled" to another element, it should be understood that the elements can be directly connected to the other element or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element or elements are referred to herein as being "disposed on a substrate," it should be understood that the element or elements may be fully integrated, partially integrated, or in a hybrid configuration (e.g., a combination of monolithically integrated and surface-mounted components, among other examples), with one or more portions formed, mounted, or embedded within the substrate. For example, the element or elements may be monolithically integrated, where portions are fabricated directly within the substrate, or hybridly integrated, where some portions are surface-mounted, bonded, or interconnected, such as through advanced packaging techniques.

Additionally, the element or elements may be formed using any suitable semiconductor technologies (e.g., thin-film deposition, printed electronics, and/or multi-chip assembly, among other examples). In contrast, when an element or elements are referred to herein as being "directly disposed on a substrate," it should be understood that the element or elements may be formed or mounted without intervening structures between the element or elements and the substrate. However, the existence of a direct disposition does not exclude other configurations in which additional layers, interconnects, and/or embedded components may be present.

As used herein, attributes that are differently affected by stress may refer to electrical and/or operational characteristics of devices (e.g., the first device 110, the second device 112, the first pair of devices 208, the second pair of device 210, the third pair of device 214, the fourth pair of devices 216, the fifth pair of devices 220, and/or the sixth pair of devices 222, among other examples), such as voltage, current, resistance, impedance, capacitance, inductance, signal integrity, frequency response, transient response, thermal behavior, reliability metrics, and/or other operational parameters, that respond differently to stress based on a device type, a device design, and/or device material properties, among other examples.

For example, a compressive stress may cause a first device to experience enhanced performance and a second device to experience degraded performance. As another example, a tensile stress may produce cause a first device to experience degraded performance and a second device to experience an enhanced performance.

For example, compressive stress may cause an NMOS device to experience degraded performance (e.g., causing an increase in a threshold voltage, resulting in a reduced switching speed and a reduced drive strength), while a same compressive stress may cause a PMOS device to experience enhanced performance (e.g., causing a decrease in threshold voltage, leading to an improved switching speed and an improved drive strength). As another example, tensile stress may cause an NMOS device to experience enhanced performance (e.g., causing a decrease in a threshold voltage resulting in improved electron mobility), while a same tensile stress may cause a PMOS device to experience a degraded performance (e.g., causing an increase in a threshold voltage resulting in reduced hole mobility).

As used herein, matching or substantially matching material compositions and/or structural designs may refer to a degree of similarity between characteristics of two or more regions (e.g., the region 104 and/or the subsequent region, among other examples), where differences are either negligible or within an acceptable tolerance for an intended application.

As used herein, satisfying a threshold may, depending on the context, refer to a value being greater than the threshold, greater than or equal to the threshold, less than the threshold, less than or equal to the threshold, equal to the threshold, not equal to the threshold, or the like.

As used herein, a phrase referring to "at least one of" a list of items refers to any combination of those items, including single members. As an example, "at least one of: a, b, or c" is intended to cover a, b, c, a-b, a-c, b-c, and a-b-c, as well as any combination with multiple of the same item.

As used herein, a phrase referring to "at least one of" a list of items refers to any combination and permutation of those items, including single members (e.g., an individual item in the list of items). As an example, "at least one of: a, b, or c" is intended to cover a, b, c, a-b, a-c, b-c, and a-b-c, as well as any combination with multiple of the same item. As used herein, the term "and/or" used to connect items in a list refers to any combination and any permutation of those items, including single members (e.g., an individual item in the list of items). As an example, "a, b, and/or c" is intended to cover a, b, c, a-b, a-c, b-c, and a-b-c.

No element, act, or instruction described herein should be construed as critical or essential unless explicitly described as such. Also, as used herein, the articles "a" and "an" are intended to include one or more items and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, or a combination of related and unrelated items), and may be used interchangeably with "one or more." Where only one item is intended, the phrase "only one" or similar language is used herein. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of").

In the preceding specification, various example embodiments have been described with reference to the accompanying drawings. It will, however, be evident that various modifications and changes may be made thereto, and additional embodiments may be implemented, without departing from the broader scope of the invention as set forth in the claims that follow. The specification and drawings are accordingly to be regarded in an illustrative rather than restrictive sense.

## Claims

1. A system, comprising:
circuitry configured to:
regulate at least one of a voltage or a current of a first device and a second device disposed on a substrate at a location associated with a region of the substrate;
measure attributes of the first device and the second device;
determine, based on the attributes, values indicative of stress associated with the region; and
generate a representation of the values indicative of the stress associated with the region.

2. The system of claim 1, wherein the values indicative of the stress associated with the region are include at least one of at least one of:
one or more stress magnitudes,
one or more stress directions,
one or more stress types,
one or more stress variabilities, and
one or more stress distributions.

3. The system of claim 1 or 2, wherein the circuitry is further configured to:
adjust, based on at least one of the values or the representation, one or more parameters, creating adjusted one or more parameters, to modify how the stress interacts with a subsequent region of a subsequent substrate formed based on the adjusted one or more parameters.

4. The system of any one of the claims 1 to 3, wherein the circuitry is further configured to:
classify, based on at least one of the values or the representation, the substrate into a category.

5. The system of any one of the claims 1 to 4, wherein the circuitry is further configured to:
determine, based on at least one of the values or the representation, a confidence score indicative of a likelihood of failure to occur at the region; and
provide, based on the confidence score satisfying a threshold, a request associated with the substrate.

6. The system of any one of the claims 1 to 5, wherein the circuitry is further configured to:
determine, based on at least one of the values or the representation, a predicted time of failure for the region.

7. The system of any one of the claims 1 to 6, wherein the values corresponding to a first time in which the substrate is part of a wafer and a second time in which the substrate is part of a package.

8. The system of any one of the claims 1 to 7, wherein
the first device is a not AND (NAND) ring oscillator array and the second device is a not OR (NOR) ring oscillator array.

9. The system of any one of the claims 1 to 8, wherein the region is at least one of:
associated with an edge of the substrate,
associated with a corner of the substrate, or
associated with a sensitive area of the substrate.

10. The system of any one of the claims 1 to 9, wherein
at least a portion of the attributes is differently affected by stress.

11. The system of any one of the claims 1 to 10, wherein the circuitry is further configured to
regulate a voltage supplied to at least one of the first device or the second device to enhance an accuracy of the attributes;
and/or
calibrate at least one of the first device or the second device to enhance an accuracy of the attributes.

12. The system of any one of the claims 1 to 11, wherein
the attributes include shifts caused by the stress associated with the region;
and/or
the attributes include differential measurements.

13. The system of any one of the claims 1 to 12, wherein
the circuitry, to measure the attributes of the first device and the second device, is further configured to:
differentially measure the attributes of the first device and the second device.

14. A device, comprising:
a substrate including a region;
a first device and a second device disposed on the substrate in proximity to the region; and
circuitry configured to:
measure first attributes of the first device and second attributes of the second device,
wherein the first attributes and the second attributes are associated with
stress associated with the region;
wherein in particular
the device comprises at least one of the following features:
(A) the first device and the second device are configured to operate, at least during a first time in which the substrate is part of a wafer and a second time in which the substrate is part of a package;
(B) the circuitry is further configured to:
regulate a voltage of at least one of the first device or the second device to enhance an accuracy of at least one of the first attributes or the second attributes;
(C) the first device is an n-type metal-oxide-semiconductor (NMOS) device and the second device is a p-type metal-oxide-semiconductor (PMOS) device.

15. A method, comprising:
measuring, by a device, attributes of a first device and a second device disposed on a substrate at a location corresponding to a region of the substrate;
determining, by the device and based on the attributes, values indicative of stress associated with the region; and
generating a representation of the values indicative of the stress associated with the region.
